# EUROPÄISCHE PATENTSCHRIFT

(11) **EP 3 108 509 B1**
(45) Veröffentlichungstag und Bekanntmachung des Hinweises auf die Patenterteilung: **26.09.2018**
(21) Anmeldenummer: 15703947.0
(22) Anmeldetag: 03.02.2015
(51) Int. Cl.: H01L 31/18

(54) **HERSTELLUNG VON ELEKTRONISCHEN BAUTEILEN AUF EINEM SUBSTRAT**
PRODUCTION OF ELECTRONIC COMPONENTS ON A SUBSTRATE
PRODUCTION DE COMPOSANTS ÉLECTRONIQUES SUR UN SUBSTRAT

(30) Priorität: 19.02.2014 DE 102014202985
(43) Veröffentlichungstag der Anmeldung: 28.12.2016
(73) Patentinhaber: Forschungszentrum Jülich GmbH, 52425 Jülich (DE)
(72) Erfinder: MERDZHANOVA, Tsvetelina, 52062 Aachen (DE); BERGFELD, Stefan, 52062 Aachen (DE)
(86) Internationale Anmeldenummer: PCT/EP2015/052170
(87) Internationale Veröffentlichungsnummer: WO 2015/124419

(56) Entgegenhaltungen:
- EP-A1- 0 858 110
- EP-A1- 2 395 567
- EP-A2- 1 054 458
- DE-A1- 19 851 873
- DE-A1-102011 014 795
- JP-A- 2013 022 731
- US-A1- 2003 162 312
- US-A1- 2013 032 282

## Beschreibung

Die vorliegende Erfindung betrifft ein Verfahren zur Herstellung von elektronischen Bauteilen auf einem transparenten Substrat.

Aus dem Stand der Technik ist bekannt, für eine Herstellung Schichten eines Solarmoduls auf bzw. oberhalb eines transparenten Substrats abzuscheiden. Das transparente Substrat wird so Bestandteil des Solarmoduls. Es werden mit geringem Aufwand herzustellende Substrate eingesetzt, um die Kosten zu minimieren.

Aus der US 2003/0040164 A1 geht ein Herstellungsverfahren hervor, bei dem eine Schicht eines Bauteils von einem transparenten Substrat mittels Laser abgelöst wird. Auch die US 2007/0096130 A1 offenbart ein derartiges Verfahren.

Aus der DE 102011014795 ist ein Verfahren zur Herstellung eines elektronischen Bauteils bekannt, bei dem auf ein für das Licht eines Lasers transparentes Substrat eine durch Laserlicht schmelzbare elektrisch leitfähige Schicht abgeschieden wird, wobei die durch das Laserlicht schmelzbare Schicht von dem Substrat durch Bestrahlen mit dem Licht des Lasers wieder gelöst werden kann.

Mit der vorliegenden Erfindung wird das Ziel verfolgt, elektronische Bauteile auf Substraten herzustellen, ohne auf preiswerte und daher technisch einfache Substrate angewiesen zu sein.

Zur Lösung der Aufgabe umfasst ein Herstellungsverfahren die Merkmale des Anspruchs 1. Vorteilhafte Ausgestaltungen ergeben sich aus den Unteransprüchen.

Zur Lösung der Aufgabe wird ein Substrat bereitgestellt, welches für Licht eines eingesetzten Lasers durchlässig ist. Auf das Substrat wird eine durch Laserlicht schmelzbare oder verdampfbare Schicht, vorzugsweise eine Metallschicht und zwar beispielsweise eine aus Silber bestehende Schicht oder eine aus Aluminium bestehende Schicht, aufgetragen. Besonders bevorzugt besteht die Schicht aus Molybdän insbesondere für die Herstellung von CIGS-Solarzellen oder aus Gold insbesondere für die Herstellung von OLEDs oder organische Solarzellen.

Hierauf werden weitere Schichten aufgetragen, die für die Herstellung des gewünschten elektronischen Bauteils erforderlich sind. Nach der teilweisen oder vollständigen Herstellung des elektronischen Bauteils auf dem Substrat wird die durch Laserlicht schmelzbare oder verdampfbare Schicht von dem Substrat abgelöst und zwar durch Licht des eingesetzten Lasers, welches durch das Substrat hindurch auf die durch Laserlicht schmelzbare oder verdampfbare Schicht gelenkt wird, um so die durch Laserlicht schmelzbare oder verdampfbare Schicht abzutrennen.

Die durch Laserlicht schmelzbare oder verdampfbare Schicht ist elektrisch leitfähig, um beim elektronischen Bauteil einen elektrischen Rückkontakt bilden zu können.

Es hat sich gezeigt, dass durch Laserlicht schmelzbare oder verdampfbare Schichten von einem transparenten Substrat abgelöst werden können, ohne das Substrat oder die durch Laserlicht schmelzbare oder verdampfbare Schicht nachhaltig zu beschädigen. Dies ermöglicht es, das Substrat wieder zu verwenden. Es können daher auch technisch aufwändige Substrate mit Vorteil eingesetzt werden, da diese erneut für die Herstellung von weiteren elektronischen Bauteilen eingesetzt werden können.

In einer Ausgestaltung der Erfindung wird nach der Herstellung des elektronischen Bauteils eine flexible Folie aufgebracht und zwar auf einer der Schichten des elektronischen Bauteils. Im Anschluss daran wird das elektronische Bauteil zusammen mit der Folie vom Substrat gelöst. Es steht im Anschluss daran ein elektronisches Bauteil zur Verfügung, welches sich auf der flexiblen Folie befindet. Es wird so ein biegsames elektronisches Bauteil hergestellt, da die grundsätzlich sehr dünnen Schichten des elektronischen Bauteils regelmäßig ebenfalls biegsam sind. Das elektronische Bauteil kann dann auf einer gewölbten Oberfläche angebracht werden, so zum Beispiel auf ein gewölbtes Dach eines Automobils. Es ist also möglich, das elektronische Bauteile flexibel auf Untergründen anzubringen, die nicht zwingend eben sein müssen. Ein biegsames Bauteil ist außerdem vorteilhaft verbessert mechanischen Belastungen gewachsen.

In einer Ausgestaltung der Erfindung wird nach der Herstellung des elektronischen Bauteils ein festes Substrat aufgebracht und zwar auf einer der Schichten des elektronischen Bauteils. Es kann sich um ein übliches Substrat handeln, um einen Untergrund für das elektronische Bauteil bereitzustellen.

Nach dem Ablösen des elektronischen Bauteils wird in einer Ausgestaltung der Erfindung eine Schicht, beispielsweise eine Folie, auf die durch Laserlicht schmelzbare oder verdampfbare Schicht aufgebracht, um so einen ergänzenden Schutz für das Bauteil zu schaffen.

Durch die Erfindung können auch unter Berücksichtigung von wirtschaftlichen Überlegungen teure Substrate wie Einkristalle eingesetzt werden oder technisch aufwändig vorbehandelte Substrate. In einer Ausführungsform werden oberflächenstrukturierte Substrate eingesetzt, um so die Struktur eines elektronischen Bauteils zu prägen oder aber um so ein gewölbtes elektronisches Bauteil herzustellen. Ein Substrat mit einer strukturierten Oberfläche weist eine dreidimensional gestaltete Oberfläche auf, die also nicht lediglich planparallel ist.

Als Einkristalle, die als Substrat dienen, können beispielsweise GaAlAs, Si, Ge, Saphir, Diamant, ZnSe, CaSO₂, CaCO₃, GaAs, GaAs, GaN, GaAlN verwendet werden, da diese in gewissen Wellenlängenbereichen transparent sind. Außerdem können Substrate mit teuren Verfahren wie Elektronenstrahl-Lithographie oder Nanoimprint-Lithographie so vorstrukturiert werden, dass z. B. das "Light Trapping" verbessert wird. Die Schicht, die mit Laserlicht vom Substrat gelöst wird, besteht zum Beispiel aus Silber, Platin, Aluminium, Gold oder Molybdän.

Insbesondere wird das verwendete Substrat nach dem Ablösen wieder verwendet, um hierauf ein nächstes elektronisches Bauteil herzustellen.

In einer Ausgestaltung der Erfindung wird die durch Laserlicht schmelzbare oder verdampfbare Schicht mithilfe von Laserpulsen und zwar insbesondere mithilfe von sehr kurzen Laserpulsen vom Substrat gelöst. Es ist so möglich, selbst sehr dünne durch Laserlicht schmelzbare oder verdampfbare Schichten vom Substrat zu lösen, die beispielsweise lediglich bis zu 0,5 µm dick sind. Die Zeitdauer eines Pulses des Laserlichts beträgt vorzugsweise weniger als 100 ps (also 100 Pikosekunden), besonders bevorzugt weniger als 50 ps. Durch Laserpulse wird sichergestellt, dass lediglich ein dünner Oberflächenbereich von wenigen nm aufgeschmolzen wird, um dann die durch Laserlicht schmelzbare oder verdampfbare Schicht vom Substrat zu lösen. Es hat sich auch herausgestellt, dass vor allem eine Metallschicht die Schichten des elektronischen Bauteils vor der Wärmeentwicklung während des Ablösens geeignet zu schützen vermag, um thermisch bedingte Beschädigungen zu vermeiden.

Während der Herstellung können ein oder mehrere oberhalb des Substrats aufgebrachte Schichten strukturiert werden. Es kann also zunächst eine aufgebrachte Schicht strukturiert werden, bevor eine weitere Schicht aufgebracht wird. Mit Strukturierung ist gemeint, dass die Oberfläche einer Schicht dreidimensional gestaltet wird oder aber dass die Schicht bereichsweise vollständig entfernt wird, um so beispielsweise eine darunter befindliche Schicht elektrisch kontaktieren oder aber verbleibende Bereiche der Schicht elektrisch voneinander trennen zu können. Diese Ausgestaltung ist von Vorteil, um beispielsweise eine Mehrzahl von Solarzellen herzustellen, die miteinander verschaltet sind.

In einer Ausgestaltung der Erfindung ist das Substrat eine Walze, die drehbar gelagert ist und die grundsätzlich durch einen Antrieb, beispielsweise einen elektrischen Antrieb, gedreht werden kann. Diese Ausgestaltung ermöglicht es, unterschiedlich lange elektronische Bauteile herstellen zu können, ohne dafür entsprechend lange Substrate bereitstellen zu müssen. Es können vor allem beliebig lange Substrate hergestellt werden.

In einer Ausgestaltung der Erfindung wird eine Solarzelle oder eine OLED hergestellt. Das Verfahren eignet sich insbesondere für die Herstellung von CIGS-Solarzellen oder Solarzellen auf Basis von Silizium, da diese bei hohen Temperaturen hergestellt werden müssen und das Verfahren es ermöglicht, dafür besonders geeignete Substrate mit Vorteil bereitzustellen.

Das Verfahren wird ferner mit Vorteil für die Herstellung von n-i-p-Si-Dünnschicht Solarzellen eingesetzt und/oder wenn spezielle Substratkonfigurationen von Vorteil sind. Das Verfahren wird insbesondere dann mit Vorteil für die Herstellung von organischen Solarzellen und OLEDs eingesetzt, um nach einem Ablösen des Substrats das Bauteil zu verkapseln, so dass zum Beispiel Barriereschichten vorgesehen werden können, die nicht vorher aufgebracht werden können. Es können mit Vorteil insbesondere auch CdTe, Perovskit und Kesterit-CuZnGaSe-Solarzellen hergestellt werden. Besonders vorteilhaft ist das Verfahren für die Herstellung von Farbstoff/Gretzel-Solarzellen, da dann viel weniger Titan eingesetzt werden kann.

In einer Ausgestaltung der Erfindung wird die durch Laserlicht schmelzbare oder verdampfbare Schicht, also insbesondere die Metallschicht, die von dem Substrat gelöst worden ist, im Anschluss daran von dem elektronischen Bauteil entfernt. Diese durch Laserlicht schmelzbare oder verdampfbare Schicht dient dann also lediglich als Zwischenschicht. Ist das elektronische Bauteil zusammen mit der Zwischenschicht vom Substrat gelöst worden, so wird die Zwischenschicht entfernt, um beispielsweise das verbleibende Bauteil geeignet weiter bearbeiten oder vervollständigen zu können. Die Zwischenschicht kann aus einem Kunststoff bestehen, der mit einem Lösungsmittel gelöst werden kann. Es können aber auch Metalle eingesetzt sein, die durch Ätzen entfernt werden können. Es kann so flexibel auf den Bedarf für die Herstellung eines elektronischen Bauteils reagiert werden.

Um zerstörungsfrei abzulösen hat sich die folgende Vorgehensweise bei Metallschichten als geeignet herausgestellt:
Die Pulsdauer des Laserlichts wird so eingestellt, dass die Wärmeeindringtiefe klein im Vergleich zur Dicke der Schicht ist, die vom Substrat gelöst wird. Die Energiedichte des Laserlichts wird so gewählt, dass abgelöst wird, jedoch nicht derart groß, dass die Schicht zerrissen wird. Insbesondere bei zu hoher Energiedichte bildet sich eine "Wolke" aus verdampftem Metall, die die Metallschicht mit einem hohen Dampfdruck zerstören kann.

Es sind regelmäßig Energiedichten von typischerweise 0,05 bis 0,5 J/cm² zu verwenden. Geeignete Energiedichten hängen von den Eigenschaften des Metalls ab (insb. Reflexion, Wärmeleitung, Wärmekapazität, Schmelz- und Verdampfungsenthalpie).

Je dicker die abzulösende Schicht ist, desto höher darf die Energiedichte sein, da die Schicht wegen der Dicke robuster ist.

Günstig ist die Wahl einer Wellenlänge, bei der das Licht des Lasers stark
absorbiert wird. Günstig ist auch eine Wellenlänge, bei der das Metall nicht so stark reflektiert wird. Bei weniger Reflektion wird mehr Energie in das Metall eingekoppelt. Die Laserenergie kann daher besser ausgenutzt werden (effizienter Prozess),

Die Repetitionsrate des Laserpulses sollte so gering gewählt werden, dass das Metall etwas Zeit zum Abkühlen hat. Dieser Parameter ist jedoch weniger kritisch. Versuche funktionierten bei 10 und 500Hz. Es ist zu erwarten, dass
auch Repetitionsraten von 1 MHz und drüber funktionieren.

Besonders günstig ist ein homogenes Strahlprofil (sog. TopHat). Bei einem solchen Strahlprofil gibt es im Zentrum nicht viel zu viel Energie, was die Metallschicht dort schon zerstörten könnte, während im Randbereich dann zu wenig Energie zum Ablösen vorhanden wäre.

Im Rahmen von Versuchen wurde erfolgreich ein System mit einem Ultrakurzpulsaser mit Pulsdauern von 12 bis 40 ps, (und zwar ein Lightwave
Seed-Laser mit regenerativem Verstärker und Nachverstärker) der Pulsenergie bis 9mJ (hinter dem Nachverstärker bei einer Lichtwellenlänge von 1064 nm) für ein Ablösen von Metallschichten von einem transparenten Substrat eingesetzt. Wellenlänge von 1064nm sowie 532nm waren möglich. Die Repetitionsrate des Laserpulses betrug 500Hz.

Weiter wurde erfolgreich ein System basierend auf einem ps-Laser der Fa. Continuum, Pulsenergie bis zu 100mJ bei 1064nm Wellenlängen, mit möglichen Lichtwellenlängen von 1064nm, 532 nm sowie 355nm eingesetzt. Die Repetitionsrate des Laserpulses betrug 10Hz.

Beide Systeme konnten durch Optisch-Parametrische Erzeugung durchstimmbarer Strahlung im Wellenlängenbereich von 12 µm bis 355nm erzeugen. Diese Eigenschaft spielte jedoch nur eine untergeordnete Rolle.

Mit den Lasersystemen konnten u. a. dünne Silber- und Aluminiumschichten erfolgreich von Glassubstraten abgelöst werden. Dabei blieben die Metallschichten intakt. Die Glasoberfläche war anschließend sichtbar sauber (optisch ohne Rückstände). Zunächst lösten sich die Metalle nur im Bereich des Laserpulses ab. Durch gute Anpassung der Energiedichte (Pulsenergie dividiert durch Fläche des Laserflecks) wurden die Metallschichten zwar abgelöst, rissen aber am Rand des Strahlflecks nicht ein. Durch Aneinanderreihung von Laserflecken aneinander konnten so Metallfilme von mehreren cm² ohne Einreißen abgelöst werden. Durch Homogenisierung der Intensitätsverteilung des Lasers (Einsatz von Blenden, Strahlformungselemente waren auch möglich) konnte die Qualität der Filme bzw. das Prozessfenster einer intakten Ablösung vergrößert werden.

Weiterhin wurden Versuche an elektronischen Bauteilen unternommen. Eine Metallschicht (Aluminium incl. Bedruckung) konnten intakt von einer als Substrat dienenden Polycarbonatmatrix abgelöst werden. Die Struktur der Polycabonatoberfläche blieb im Metallfilm vollständig erhalten (Beobachtung unter dem Mikroskop). Das Polycabonatsubstrat und insb. die

Oberfläche blieben komplett intakt. Auch hier blieb die Struktur erhalten und die Oberfläche enthielt keine sichtbaren Metallreste.

Es wurden auch erfolgreich Pt-Filme von Saphir und AI- und Pt-Filme von Silizium abgelöst. Beispielsweise konnten mit Laserpulsen von unter 100ps Filme mit einer Dicke von weniger als 0,5 µm intakt abgelöst werden.

Es zeigen
- Figur 1:: elektronisches Bauteil auf strukturiertem Substrat;
- Figur 2:: elektronisches Bauteil vom Substrat abgelöst;
- Figur 3:: Herstellungsschritte für elektronisches Bauteil;
- Figur 4:: Herstellungsschritte für elektronisches Bauteil mit Strukturierungsschritten;
- Figur 5:: Herstellung auf Walze;
- Figur 6:: Herstellung eines gewölbten Bauteils.

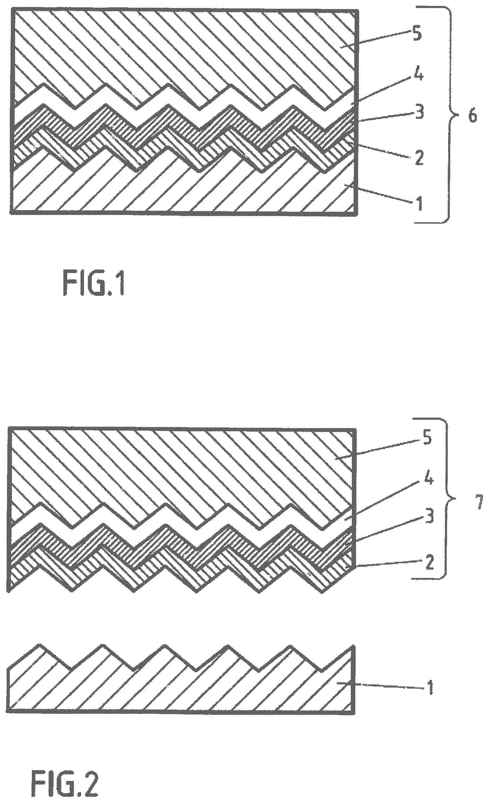

Die Figur 1 zeigt ein für das Licht eines Lasers transparentes Substrat 1 mit einer zickzackförmig strukturierten Oberfläche. Auf die strukturierte Oberfläche ist eine metallische Schicht 2 aufgebracht. Hierauf sind ein oder mehrere aktive Schichten wie dotierte Schichten und/ oder Absorberschichten 3 aufgebracht worden. Oberhalb der Schichten 3 befindet sich ein transparenter elektrischer Kontakt 4. Auf dem elektrischen Kontakt 4 ist eine als Träger dienende Schicht 5 aufgetragen worden. Es kann sich dabei um eine Folie handeln. Im einfachsten Fall wird diese aufgeklebt. Die Folie kann bereits einen Klebstofffilm umfassen, durch den die Folie mit dem elektronischen Bauteil verbunden wird. Es ist so ein Schichtaufbau 6 geschaffen worden, der das transparente Substrat 1 sowie ein elektronisches Bauteil nebst Träger umfasst.

Die Figur 2 zeigt die Situation nach dem Ablösen des transparenten Substrats 1 von der metallischen Schicht 2 mithilfe von Laserlicht. Die Strukturierung ist in dem elektronischen Bauteil erhalten geblieben. Dieses befindet sich auf einem Träger 5, der technisch einfach und daher preiswert sein kann, also zum Beispiel eine flexible Folie. Das Substrat 1 kann wieder verwendet werden. Es können daher auch andere Substrate wie Einkristalle eingesetzt werden, ohne dass wirtschaftliche Überlegungen dagegen sprechen würden.

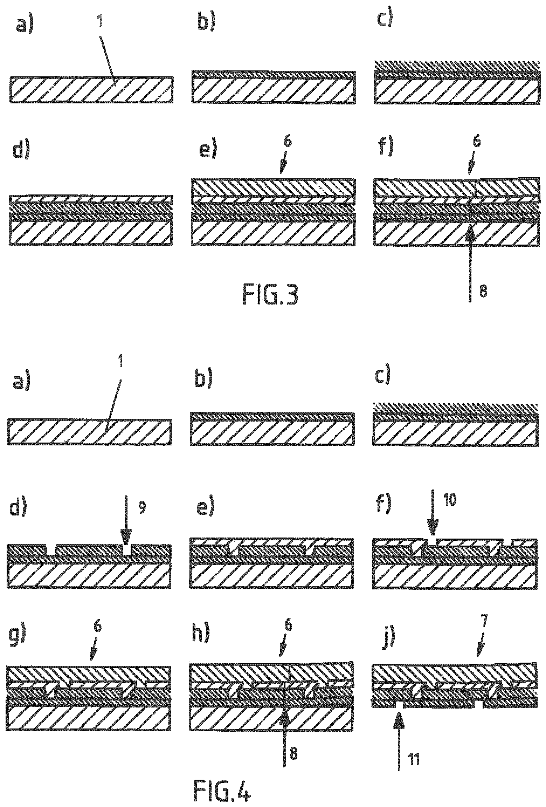

Die Figur 3 verdeutlicht die Herstellungsschritte durch sechs Abbildungen a) bis f). Zunächst wird ein für Laserlicht transparentes Substrat 1 gemäß Abbildung a) bereitgestellt. Gemäß Abbildung b) werden ein oder mehrere weitere aktive Schichten aufgebracht. Gemäß Abbildung d) wird oberhalb der aktiven Schichten ein Rückkontakt aufgebracht. Gemäß Abbildung e) wird auf dem Rückkontakt eine Trägerfolie aufgebracht. Schließlich wird gemäß Abbildung f) Laserlicht 8 durch das transparente Substrat geleitet, um wie angedeutet schrittweise das elektronische Bauteil vom Substrat abzulösen.

Die Figur 4 verdeutlicht mögliche Herstellungsschritte durch insgesamt neun Abbildungen a) bis j). Die Abbildungen a) bis c) der Figur 4 zeigen die Schritte aus den Abbildungen a) bis c) der Figur 3. Gemäß Abbildung d) wird nun jedoch eine Strukturierung vorgenommen. So werden Bereiche der aktiven Schichten entfernt, so durch ein Durchlass zur metallischen Schicht besteht. Gemäß Abbildung e) wird hierauf ein Rückkontakt aufgebracht, der gemäß Abbildung f) wiederum strukturiert werden kann. Schließlich wird gemäß Abbildung g) eine Trägerfolie aufgebracht und das Substrat gemäß Abbildung h) von der metallischen Schicht mithilfe von Laserlicht 8 gelöst. Schließlich kann gemäß Abbildung J die metallische Schicht wiederum strukturiert werden, indem Bereiche 11 entfernt werden.

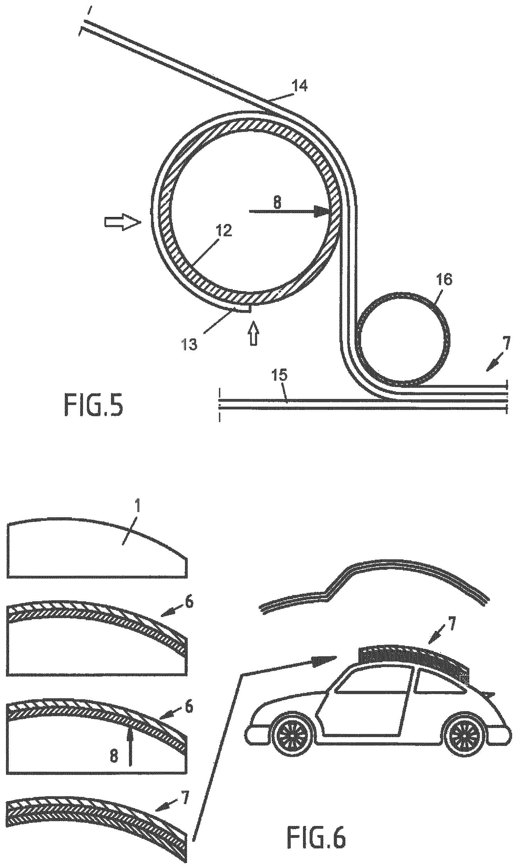

Die Figur 5 zeigt eine transparente Walze 12, durch die das Licht 8 eines Lasers hindurch gelenkt werden kann, umso die metallische Schicht eines elektronischen Bauteils von der Walze 12 abzulösen. Material kann von unten oder seitlich wie durch Pfeile angedeutet auf die Walze 12 aufgetragen werden und zwar zunächst eine aus Metall bestehende Schicht. Sind so die Schichten des elektronischen Bauteils auf der Walze hergestellt worden, so kann schließlich noch eine Folie 14 zugeführt und mit den Schichten 13 verbunden werden. Abschließend wird die metallische Schicht durch das Licht 8 von der Walze abgelöst. Es kann nun noch eine Folie 15 alternativ oder ergänzend mit den Schichten 13 verbunden werden. Hierfür kann eine Umlenkrolle 16 wie dargestellt hilfreich sein, über die die Schichten 13 umgelenkt werden. Im Anschluss daran kann das so hergestellte elektronische Bauteil 7 konfektioniert oder aufgewickelt werden.

Die Figur 6 verdeutlicht, dass zunächst auf einem Substrat 1 die entsprechenden Schichten für ein elektronisches Bauteil aufgetragen werden. Schließlich werden die hergestellten Schichten 6 des elektronischen Bauteils vom Substrat 1 mithilfe von Laserlicht gelöst und das so hergestellte Bauteil 7 auf einem gebogenen Untergrund, so zum Beispiel auf dem Dach eines Pkws, befestigt.

Bezugszeichen:
1 = Substrat
2 ,3,4, = Schichten
5 = Träger
6 = Schichtaufbau komplett
7= Schichtaufbau ohne Substrat
8= Laserablösung
9= Strukturierung
10 = Strukturierung
11 = Strukturierung
12 = Walze
13 = ein oder mehrere Schichten
14 = Folie
15 = Folie
16 = Umlenkrolle

## Patentansprüche

1. Verfahren zur Herstellung eines elektronischen Bauteils mit den Schritten:
• auf ein für das Licht (8) eines Lasers transparentes Substrat (1, 12) wird eine durch Laserlicht schmelzbare oder verdampfbare, elektrisch leitfähige Schicht (2) abgeschieden,
• hierauf werden weitere Schichten (3, 4) des elektronischen Bauteils abgeschieden,
• die durch Laserlicht schmelzbare oder verdampfbare Schicht (2) wird von dem Substrat (1) durch Bestrahlen mit dem Licht (8) des Lasers gelöst und zwar durch das transparente Substrat (1) hindurch, **dadurch gekennzeichnet, dass** das Substrat (1) nach dem Ablösen des elektronischen Bauteils (7) erneut für die Herstellung eines elektronischen Bauteils (7) verwendet wird und dass als Substrat eine sich drehende Walze (12) eingesetzt wird.

2. Verfahren nach Anspruch 1, **dadurch gekennzeichnet, dass** die durch Laserlicht schmelzbare oder verdampfbare, elektrisch leitfähige Schicht (2) eine Metallschicht ist.

3. Verfahren nach dem vorhergehenden Anspruch, **dadurch gekennzeichnet, dass** die aus Metall bestehende Schicht (2) aus Silber, Gold oder Aluminium besteht.

4. Verfahren nach einem der vorhergehenden Ansprüche, **dadurch gekennzeichnet, dass** nach dem Aufbringen der weiteren Schichten (3, 4) eine flexible Folie (5, 14) auf eine der weiteren Schichten (3, 4) aufgebracht wird und im Anschluss daran die durch Laserlicht schmelzbare oder verdampfbare Schicht (2) vom Substrat (1) gelöst wird.

5. Verfahren nach dem vorhergehenden Anspruch, **dadurch gekennzeichnet, dass** das vom Substrat gelöste elektronische Bauteil (7) auf einer gewölbten Oberfläche aufgebracht wird.

6. Verfahren nach einem der vorhergehenden Ansprüche, **dadurch gekennzeichnet, dass** als Substrat (1) ein Einkristall, ein vorbehandeltes Substrat (1) und/oder ein Substrat (1) mit einer strukturierten Oberfläche eingesetzt wird.

7. Verfahren nach einem der vorhergehenden Ansprüche, **dadurch gekennzeichnet, dass** mithilfe von Laserpulsen die durch Laserlicht schmelzbare oder verdampfbare Schicht (2) vom Substrat gelöst wird, wobei die Dauer eines Pulses vorzugsweise weniger als 100 ps, besonders bevorzugt weniger als 50 ps beträgt.

8. Verfahren nach einem der vorhergehenden Ansprüche, **dadurch gekennzeichnet, dass** ein oder mehrere oberhalb des Substrats (1) aufgebrachte Schichten (3, 4) strukturiert werden und zwar vorzugsweise vor dem Ablösen vom Substrat (1).

9. Verfahren nach einem der vorhergehenden Ansprüche, **dadurch gekennzeichnet, dass** eine Solarzelle oder eine OLED hergestellt wird.

## Claims

1. Method of producing an electronic component, comprising the steps:
• depositing an electrically conductive layer (2) that can be melted or evaporated by laser light on a substrate (1, 12) transparent to the light (8) of a laser,
• depositing further layers (3, 4) of the electronic component thereon,
• detaching the layer (2) that can be melted or evaporated by laser light from the substrate (1) by irradiation with the light (8) of the laser, particularly through the transparent substrate (1), **characterised in that**, after the detachment of the electronic component (7), the substrate (1) is used again for the production of an electronic component (7) and that a rotating roller (12) is used as the substrate.

2. Method according to claim 1, **characterised in that** the electrically conductive layer (2) that can be melted or evaporated by laser light is a metal layer.

3. Method according to the preceding claim, **characterised in that** the layer (2) consisting of metal consists of silver, gold or aluminium.

4. Method according to one of the preceding claims, **characterised in that**, after the application of the further layers (3, 4), a flexible film (5, 14) is applied to one of the further layers (3, 4) and the layer (2) that can be melted or evaporated by laser light is subsequently detached from the substrate (1).

5. Method according to the preceding claim, **characterised in that** the electronic component (7) detached from the substrate is applied to a curved surface.

6. Method according to one of the preceding claims, **characterised in that** a single crystal, a pretreated substrate (1) and/or a substrate (1) with a structured surface is used as the substrate (1).

7. Method according to one of the preceding claims, **characterised in that** the layer (2) that can be melted or evaporated by laser light is detached from the substrate with the aid of laser pulses, the duration of a pulse preferably being less than 100 ps, particularly preferably less than 50 ps.

8. Method according to one of the preceding claims, **characterised in that** one or more layers (3, 4) applied above the substrate (1) is/are structured, preferably before being detached from the substrate (1).

9. Method according to one of the preceding claims, **characterised in that** a solar cell or an OLED is produced.

## Revendications

1. Procédé pour fabriquer un composant électronique comportant les étapes dans lesquelles :
• on dépose, sur un substrat (1, 12) transparent à la lumière (8) d'un laser, une couche (2) conductrice de l'électricité, pouvant être fondue ou évaporée par la lumière d'un laser,
• on y dépose des couches (3, 4) supplémentaires du composant électronique,
• on détache du substrat la couche (2) pouvant être fondue ou évaporée par la lumière d'un laser par exposition à la lumière (8) du laser, et cela au travers du substrat (1) transparent, **caractérisé en ce que** l'on utilise le substrat (1) après détachement du composant (7) électronique à nouveau pour la fabrication d'un composant (7) électronique et l'on utilise comme substrat un cylindre (12) rotatif.

2. Procédé suivant la revendication 1, **caractérisé en ce que** la couche (2) conductrice de l'électricité, pouvant être fondue ou évaporée par la lumière d'un laser, est une couche métallique.

3. Procédé suivant la revendication précédente, **caractérisé en ce que** la couche (2) constituée de métal est constituée d'argent, d'or ou d'aluminium.

4. Procédé suivant l'une des revendications précédentes, **caractérisé en ce que**, après le dépôt des couches (3, 4) supplémentaires, on dépose une feuille (5, 14) souple sur l'une des couches (3, 4) supplémentaires et, à la suite de cela, on détache du substrat (1) la couche (2) pouvant être fondue ou évaporée par la lumière d'un laser.

5. Procédé suivant la revendication précédente, **caractérisé en ce que** l'on dépose le composant (7) électronique détaché du substrat sur une surface incurvée.

6. Procédé suivant l'une des revendications précédentes, **caractérisé en ce que** l'on utilise comme substrat (1) un monocristal, un substrat (1) prétraité et/ou un substrat (1) à surface structurée.

7. Procédé suivant l'une des revendications précédentes, **caractérisé en ce que** l'on détache du substrat la couche (2) pouvant être fondue ou évaporée par la lumière d'un laser à l'aide d'impulsions laser, la durée d'une impulsion étant de préférence inférieure à 100 ps et, de manière particulièrement préférée, inférieure à 50 ps.

8. Procédé suivant l'une des revendications précédentes, **caractérisé en ce que** l'on structure une ou plusieurs couches (3, 4) déposée(s) au-dessus du substrat (1), et cela de préférence avant le détachement du substrat (1).

9. Procédé suivant l'une des revendications précédentes, **caractérisé en ce que** l'on fabrique une cellule solaire ou une OLED.
